Europäisches Patentamt

European Patent Office

Office européen des brevets

(11) Publication number: **0 026 051**
**B1**

# EUROPEAN PATENT SPECIFICATION

(45) Date of publication of patent specification: **27.08.86**

(21) Application number: **80302980.0**

(22) Date of filing: **28.08.80**

(51) Int. Cl.⁴: **H 03 K 19/013,**
**H 03 K 19/088, H 03 K 17/04**

(54) A fundamental logic circuit.

(30) Priority: **29.08.79 JP 110074/79**
**29.08.79 JP 110075/79**

(43) Date of publication of application:
**01.04.81 Bulletin 81/13**

(45) Publication of the grant of the patent:
**27.08.86 Bulletin 86/35**

(84) Designated Contracting States:
**DE FR GB NL**

(56) References cited:
**US-A-3 824 408**
**US-A-3 958 136**
**US-A-4 132 906**

**K. Kretzer "Handbuch für Hochfrequenz- und Elektrotechniker" Vol. IV Verlag für Radio-Foto-Kinotechnik, Berlin-Borsigwalde 1957, p. 692 K. Steinbuch/W. Weber: "Taschenbuch der Informatik Vol. I, 3rd edition 1974, Springer-Verlag Berlin Heidelberg New York, pp. 273-280**

(73) Proprietor: **FUJITSU LIMITED**
**1015, Kamikodanaka Nakahara-ku Kawasaki-shi Kanagawa 211 (JP)**

(72) Inventor: **Ohmichi, Hitoshi**
**2223, Shukugawara Tama-ku Kawasaki-shi Kanagawa 214 (JP)**
Inventor: **Enomoto, Hiromu**
**1-15- 1225, Kawara-cho Saiwai-ku Kawasaki-shi Kanagawa 210 (JP)**
Inventor: **Yasuda, Yasushi**
**92 Ohmaru Inagi-shi**
**Tokyo 192-02 (JP)**
Inventor: **Mitono, Yoshiharu**
**1-14-12 Sakuragaoka Setagaya-ku Tokyo 156 (JP)**
Inventor: **Imaizumi, Taketo**
**449 Koueki sue-cho**
**Kasuya-gun Fukuoka 811-21 (JP)**

(74) Representative: **Abbott, Leonard Charles et al GILL JENNINGS & EVERY 53-64 Chancery Lane London WC2A 1HN (GB)**

Courier Press, Leamington Spa, England.

## Description

The present invention relates to a fundamental logic circuit and, more particularly, to a high speed fundamental logic circuit used, for example, in an electronic computer.

In a fundamental logic circuit such as an inverter or a NAND gate having an output inverter transistor whose emitter electrode is grounded, one of the most important factors influencing the operating speed of the fundamental logic circuit is the turn off time of the output inverter transistor. In order to reduce the turn off time of the output inverter transistor, it is necessary to quickly discharge the charge stored in the base region of the output inverter transistor.

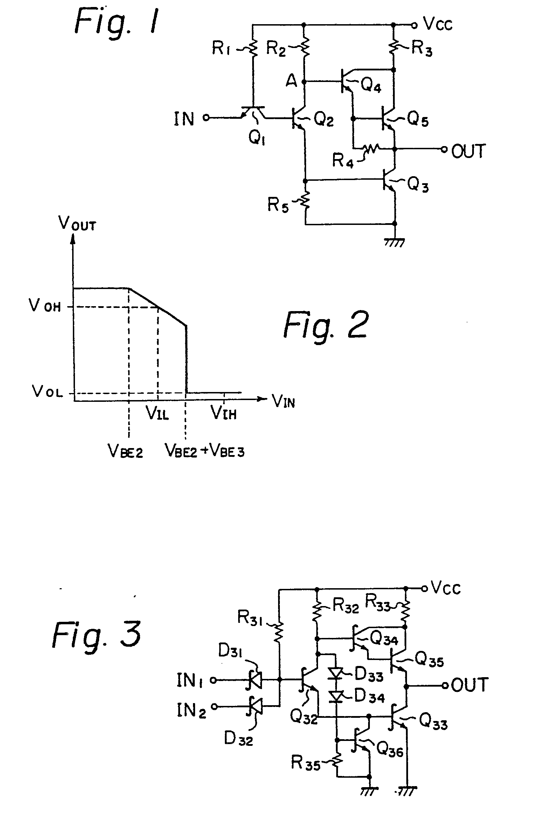

Fig. 1 illustrates a TTL inverter circuit as an example of a conventional fundamental logic circuit which has an output inverter transistor. In Fig. 1, an input transistor $Q_1$ is an NPN type transistor which switches current flowing from the positive voltage source $V_{cc}$ through a resistor $R_1$ to the base electrode of the input transistor $Q_1$ to an input terminal IN or to the base electrode of a driver transistor $Q_2$. The driver transistor $Q_2$ is an NPN type transistor which outputs both inverted and non-inverted signals of an input signal applied to the input terminal IN. An output inverter transistor $Q_3$ is an NPN type transistor which is driven by an output signal from the emitter electrode of the driver transistor $Q_2$. Transistors $Q_4$ and $Q_5$ are both NPN type transistors which constitute a Darlington transistor driven by an output signal from the collector electrode of the driver transistor $Q_2$. The transistor $Q_5$ serves as a level shift circuit which provides a potential difference between the emitter electrode of the transistor $Q_4$ and the collector electrode of the output inverter transistor $Q_3$, i.e., the output terminal OUT, and the level shift circuit can be replaced by a diode connected therebetween. The output inverter transistor $Q_3$ and the Darlington transistor consisting of the transistor $Q_4$ and $Q_5$ constitute an output stage having a so-called totem-pole structure.

The TTL inverter circuit of Fig. 1 is well known and, therefore, the general description of the operation thereof is omitted herein, and the operation thereof will be described for a condition wherein the output potential of the output terminal OUT changes from low (i.e. about 0.4 V) to high (i.e. about 3.4 V, which is the potential of the voltage source $V_{cc}-2V_{BE}$). When the potential of the input terminal IN changes from high to low, the driver transistor $Q_2$ changes from the conductive state (turned on condition) to the non-conductive state (turned off condition). Therefore, the potential of a point A, i.e., the collector electrode of the transistor $Q_2$ changes from low to high, and the potential of the emitter electrode of the transistor $Q_2$ changes from high to low. Accordingly, the transistor $Q_3$ begins to change from the turned on condition to the turned off condition. However, turning off of the

transistor $Q_3$ is not complete until the base charge stored in the base region of the transistor $Q_3$ is discharged and the transistor $Q_3$ remains in the turned on condition until the base charge is completely discharged. In order to discharge the base charge stored in the base region of the transistor $Q_3$, a resistor $R_5$ is connected between the base electrode and the emitter electrode (i.e. the ground) of the transistor $Q_3$, so that a discharge path is constituted. Therefore, although the discharge time of the base charge can be reduced by decreasing the resistance value of the resistor $R_5$, it is impossible to greatly decrease the resistance value of the resistor $R_5$. This is because, when the transistor $Q_3$ is turned on, the resistor $R_5$ provides a bypass for the base current of the transistor $Q_3$ to the ground, and if the resistance value of the resistor $R_5$ is very small, the base current becomes too small to turn on the transistor $Q_3$ completely. Therefore, in the logic circuit of Fig. 1, the turn off time of the output inverter transistor $Q_3$ cannot be very small.

Moreover, the conventional logic circuit of Fig. 1 has the disadvantage of having a poor transfer characteristic as shown in Fig. 2. Assume that the input potential $V_{IN}$ of the input terminal IN increases from low to high gradually. When the input potential $V_{IN}$ increases in the range from $V_{BE2}$ to $V_{BE2}+V_{BE3}$, the potential of the base electrode of the driver transistor $Q_2$ also increases from $V_{BE2}$ to $V_{BE2}+V_{BE3}$. Wherein, $V_{BE2}$ designates the base-emitter voltage of the transistor $Q_2$ and $V_{BE3}$ designates the base-emitter voltage of the transistor $Q_3$. In this condition, the driver transistor $Q_2$ begins to change from the turned off condition to the turned on condition, so that the current passing through a resistor $R_2$, the main current path of the driver transistor $Q_2$ and the resistor $R_5$ increases gradually. In this condition, the potential of the point A, i.e., the collector electrode of the driver transistor $Q_2$, falls gradually and, therefore, the potential of the output terminal OUT falls gradually. This is because the transistor $Q_4$ and $Q_5$ are in the turned on condition and the output inverter transistor $Q_3$ is still in the turned off condition, and the potential of the point A is transferred to the output terminal OUT through the base emitter junctions of the transistor $Q_4$ and $Q_5$. Therefore, in the input potential range from $V_{BE2}$ to $V_{BE2}+V_{BE3}$, the transfer characteristic of the conventional logic circuit is not sharp as illustrated in Fig. 2. After the input potential $V_{IN}$ becomes larger than $V_{BE2}+V_{BE3}$, the inverter transistor $Q_3$ turns on and the output potential $V_{OUT}$ falls to a low level (i.e. about 0.4 V) quickly.

Fig. 3 illustrates a two input DTL NAND gate circuit as another example of a conventional fundamental logic circuit. The circuit of Fig. 3 comprises a diode gate consisting of Schottky barrier diodes (hereinafter referred to as SBD) $D_{31}$ and $D_{32}$, and a resistor $R_{31}$. Transistors $Q_{34}$ and $Q_{35}$, which constitute a Darlington transistor device are driven by an output signal from the collector electrode of a driver transistor $Q_{32}$, and

an output inverter transistor $Q_{33}$ is driven by an output signal from the emitter electrode of the driver transistor $Q_{32}$. The Darlington transistor device consisting of the transistors $Q_{34}$ and $Q_{35}$, and the output inverter transistor $Q_{33}$ constitute a totem-pole output stage. The NAND gate circuit of Figure 3 also comprises a switching transistor $Q_{36}$ in order to quickly discharge the base charge stored in the base region of the output inverter transistor $Q_{33}$, so that the turn off time of the transistor $Q_{33}$ is reduced. The base electrode of the switching transistor $Q_{36}$ is connected to the collector electrode of the driver transistor $Q_{32}$ through diodes $D_{33}$ and $D_{34}$, and to the ground through a resistor $R_{35}$.

Operation of the switching transistor $Q_{36}$ will now be described. When the input potential $V_{IN1}$ and $V_{IN2}$ of both input terminals $IN_1$ and $IN_2$ are high, the driver transistor $Q_{32}$ is turned on and the output inverter transistor $Q_{33}$ is switched to its conductive state (turned on). Therefore, the potential of the collector electrode of the driver transistor $Q_{32}$ is low, so that the transistors $Q_{34}$ and $Q_{35}$ are both switched to their non-conductive state (turned off) and the potential of the output terminal is low. In this condition, the diodes $D_{33}$ and $D_{34}$ are turned off, and therefore the switching transistor $Q_{36}$ is turned off.

Assume that the input potential of at least one of the input terminals $IN_1$ and $IN_2$ changes to low, then the driver transistor $Q_{32}$ turns off so that the potential of the collector electrode of the transistor $Q_{32}$ becomes high. Therefore, the transistors $Q_{34}$ and $Q_{35}$ are turned on, and the output inverter transistor $Q_{33}$ is turned off. In this condition, current flows from the collector electrode of the driver transistor $Q_{32}$ through the diodes $D_{33}$ and $D_{34}$ to the base electrode of the switching transistor $Q_{36}$, and to the ground through a resistor $R_{35}$. Therefore, the switching transistor $Q_{36}$ turns on and quickly discharges the base charge stored in the base region of the output inverter transistor $Q_{33}$, so that the turn off time of the output inverter transistor $Q_{33}$ is reduced.

However, the conventional logic circuit of Figure 3 has the following disadvantages.

(1) The threshold voltage $V_{TH}$ of each of the input potentials $V_{IN1}$ and $V_{IN2}$ is as follows.

$$V_{th} = V_{CE36} + V_{BE32} - V_F \fallingdotseq 0.8 \text{ V} \qquad (1)$$

where $V_{CE36}$ is a saturated collector-emitter voltage (i.e. about 0.4 V) of the switching transistor $Q_{36}$, $V_{BE32}$ is a base-emitter voltage (i.e. about 0.8 V) of the driver transistor $Q_{32}$ and $V_F$ is a forward biased voltage (i.e. about 0.4 V) of the diode $D_{31}$ or $D_{32}$. Therefore, the threshold voltage $V_{TH}$ becomes about 0.8 V, and is smaller than that of the usual TTL gate circuit. so that the logic circuit of Figure 3 has a poor noise immunity.

(2) The current flows from the positive voltage source $V_{cc}$ through the resistor $R_{32}$, the diodes $D_{33}$ and $D_{34}$, and the resistor $R_{35}$ and the base-emitter junction of the switching transistor $Q_{36}$ to the ground all the time the driver transistor $Q_{32}$ is in the turned off condition. Therefore, the power consumption of the logic circuit is large.

(3) The logic circuit of Figure 3 uses a large number of semiconductor elements and, therefore, the circuit occupies a relatively large area in an integrated circuit.

Examples of prior fundamental logic circuits having an output inverter transistor are disclosed in the publication "The TTL Data Book for Design Engineers" First Edition, by Texas Instruments Incorporated, 1973, P. 87 and P. 89.

Another example is contained in US—A—3824408, which discloses an inverting driver circuit having a pair of serially arranged bipolar transistors in its output stage, a further transistor having its collector and emitter electrodes bridging the base and grounded emitter of one of the output transistors; the base of this further transistor is connected to the output of a logic gate which receives the input signal and the voltage at the output terminal, the further transistor being turned on by the logic gate to deplete the charge stored in the base region of the said output transistor when this output transistor is slow to turn off in response to the input signal.

Since one of the input terminals of the gate is connected to the input terminal of the device, the load of the pre-stage circuit driving the device is large, and since the other input terminal of the gate is connected to the output terminal of the device, the driving ability of the device is reduced. The use of a gate also increases the power consumption of the device.

Finally, US—A—4132906 discloses a bipolar logic circuit in which an input stage is followed by a phase splitter stage which drives a push-pull output circuit. An AC feedback circuit including a capacitance is arranged between the base of one output transistor and the base of a further transistor which, when turned on, assists in removing the base charge from the other output transistor. In such a circuit, the set-up time is greater than in a circuit embodying the present invention.

It is an object of the present invention to decrease the turn off time of the output inverter transistor from that of the conventional logic circuit so that the operating speed of the logic circuit is increased over that of the conventional logic circuit.

Other objects of the present invention are to improve the transfer characteristic of logic circuits, to decrease their power consumption and to make them more compact.

One logic circuit according to the invention comprises: an input means; a driver transistor whose base electrode is connected to the input means; an output emitter follower transistor which is driven by an output signal from the collector electrode of the driver transistor; an output inverter transistor which is driven by an output signal from the emitter electrode of the driver transistor and which, with the output emitter follower transistor, constitutes a totem-pole output stage; and a first switching transistor which is connected between the base electrode of the output inverter transistor and ground, and which removes a base charge from the base of the output inverter transistor; and is characterized by a second switching transistor of which the emitter-collector path is connected between the base electrode of the first switching transistor and a node of the logic circuit which changes in potential with the output electrode of the driver transistor more rapidly than the change in potential at the output of the output inverter transistor when the output inverter transistor changes from the conductive state to the non-conductive state, the said second switching transistor being switched to its conductive state temporarily when the output inverter transistor changes from the conductive state to the non-conductive state. Thereby the first switching transistor is switched to its conductive state temporarily.

Another logic circuit according to the invention comprises an input means; a driver transistor whose base electrode is connected to the input means; an output inverter transistor which is driven by an output signal from the emitter electrode of the driver transistor; a switching transistor which is connected between the base electrode of the output inverter transistor and ground, and which removes a base charge from the base of the output inverter transistor; and is characterized in that a capacitor is connected between the base electrode of the switching transistor and a node in the circuit which changes in potential as the state of conduction of the output inverter transistor changes, in such a manner that when the output inverter transistor changes from the conductive state to the non-conductive state the capacitor provides a temporary supply of base current to the switching transistor to cause the switching transistor to switch to the conductive state temporarily to remove the stored base charge of the output inverter transistor; and in that a diode is connected between the base electrode of the switching transistor and ground to clamp the base potential of the switching transistor when the potential of the said node changes in the opposite sense.

In order that the invention may be better understood, five embodiments of the invention are described below, with reference to the accompanying drawings, in which:—

Figure 1 is a circuit diagram illustrating a TTL inverter circuit as an example of a conventional fundamental logic circuit;

Figure 2 illustrates a transfer characteristic of the TTL inverter circuit of Figure 1;

Figure 3 is a circuit diagram illustrating a two-input DTL NAND gate as another example of a conventional fundamental logic circuit;

Figure 4 is a circuit diagram illustrating a TTL inverter circuit as a first embodiment of the present invention;

Figure 5 illustrates a transfer characteristic of the TTL inverter circuit of Figure 4;

Figure 6 is a circuit diagram illustrating a TTL inverter circuit as a second embodiment of the present invention;

Figure 7 is a circuit diagram illustrating a logic circuit as a third embodiment of the present invention;

Fig. 8 is a circuit diagram illustrating a two input DTL NAND gate as a fourth embodiment of the present invention; and,

Fig. 9 is a circuit diagram illustrating another two-input DTL NAND gate as a fifth embodiment of the present invention.

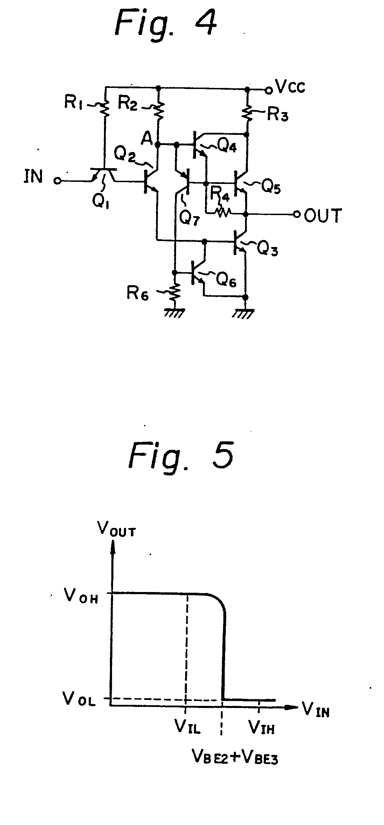

Fig. 4 illustrates a TTL inverter circuit as a first embodiment of the present invention. In Fig. 4, the same parts as appear in Fig. 1 are designated by the same reference symbols, and the explanation thereof is omitted herein. The logic circuit of Fig. 4 does not use the resistor $R_5$ of Fig. 1 and comprises a first switching transistor $Q_6$ of NPN type, whose main current path is connected between the base electrode and the emitter electrode of the output inverter transistor $Q_3$, and which discharges the base charge stored in the base region of the transistor $Q_3$. The logic circuit of Fig. 4 also comprises a second switching transistor $Q_7$ of PNP type, whose main current path is connected between the base electrode of the first switching transistor $Q_6$ and the collector electrode of the driver transistor $Q_2$, and whose base electrode is connected to the emitter electrode of the transistor $Q_4$ connected to the base electrode of the transistor $Q_5$. The collector electrode of the second switching transistor $Q_7$, which is connected to the base electrode of the first switching transistor $Q_6$, is connected to the ground through a resistor $R_6$.

As aforementioned, when the input potential $V_{IN}$ of the input terminal IN changes from high to low, the driver transitor $Q_2$ is turned off and the potential of the collector electrode of the driver transistor $Q_2$ (i.e. point A) changes from low to high. Accordingly, the output inverter transistor $Q_3$ starts to change from the turned on condition to the turned off condition, so that the output potential $V_{OUT}$ starts to change from low (i.e. about 0.4 V) to high. Before the output potential $V_{OUT}$ becomes high, a potential difference exists between the point A and the output terminal OUT, and therefore, a transient current flows from the point A through the base-emitter junction of the transistor $Q_4$ and through the base-emitter junction of the transistor $Q_5$ to the main current path of the output inverter transistor $Q_3$, so that the transistors $Q_4$ and $Q_5$ are turned on.

A part of the transient current flows through the second switching transistor $Q_7$ and the first switching transistor $Q_6$. That is, the second switching transistor $Q_7$ is supplied with the base current by the above-mentioned potential difference and is turned on. Therefore, a current passes from the point A through the main current path of the second switching transistor $Q_7$ to the base electrode of the first switching transistor $Q_6$,

so that the first switching transistor $Q_6$ is turned on. When the first switching transistor $Q_6$ is so turned on, the base charge stored in the base region of the transistor $Q_3$ is discharged through the main current path of the first switching transistor $Q_6$. Therefore, the turn off time of the output inverter transistor $Q_3$ is reduced and the output inverter transistor $Q_3$ is turned off quickly, thereby changing the output potential $V_{OUT}$ to high. In response to the change of the output potential $V_{OUT}$ from low to high, the second switching transistor $Q_7$ turns off and, thus, the first switching transistor $Q_6$ is turned off. Therefore, the transistors $Q_6$ and $Q_7$ is turned on only for a short time and steady current consumption of the logic circuit of Fig. 4 is reduced.

Fig. 5 illustrates the transfer characteristic of the logic circuit of Fig. 4. As illustrated in Fig. 5, the logic circuit of Fig. 4 has a sharper transfer characteristic than that of the conventional logic circuit of Fig. 1 illustrated in Fig. 2. When the input potential $V_{IN}$ changes from low to high, the driver transistor $Q_2$ is turned on. However, since the logic circuit of Fig. 4 does not have the resistor $R_5$, contained in the conventional logic circuit of Fig. 1, the driver transistor $Q_2$ turns on at substantially the same time as the turn on of the output inverter transistor $Q_3$ after the input potential has reached to the level of $V_{BE2}+V_{BE3}$. Therefore, the potential of the point A remains substantially at high level until the input potential $V_{IN}$ reaches the level of $V_{BE2}+V_{BE3}$, and after the input potential has reached to the level of $V_{BE2}+V_{BE3}$, the potential of the point A falls to low quickly, and thus, the output potential $V_{OUT}$ falls to low quickly. Consequently, the transfer characteristic of the logic circuit of Fig. 4 becomes very sharp.

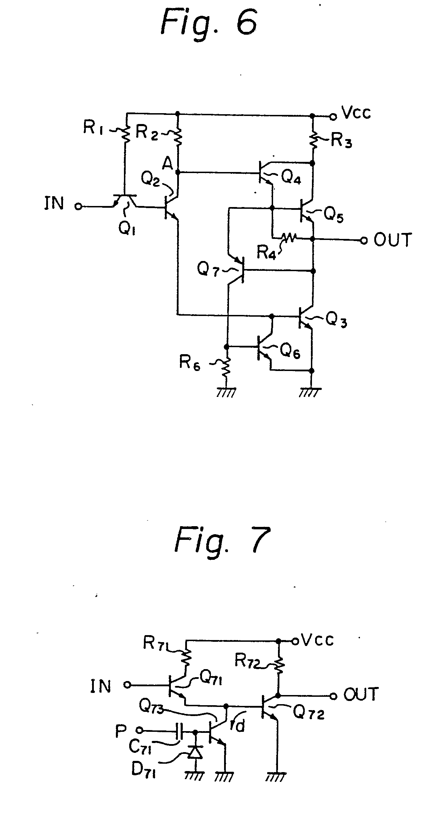

Fig. 6 illustrates a TTL inverter circuit as a second embodiment of the present invention. The TTL inverter circuit of Fig. 6 also comprises the first switching transistor $Q_6$ and the second switching transistor $Q_7$, as in the TTL inverter circuit of Fig. 4. However, the emitter electrode of the second switching transistor $Q_7$ is connected to the emitter electrode of the transistor $Q_4$, which is connected to the base electrode of the transistor $Q_5$, and the base electrode of the second switching transistor $Q_7$ is connected to the output terminal OUT. The other parts of the circuit are the same as that of the circuit of Fig. 4.

In the TTL inverter circuit of Fig. 6, the second switching transistor $Q_7$ is turned on temporarily by a part of the transient current flowing from the point A through the base-emitter junction of the transistor $Q_4$ when the input potential $V_{IN}$ changes from high to low. The other operation of the TTL inverter circuit of Fig. 6 is the same as that of the TTL inverter circuit of Fig. 4. Therefore, the turn off time of the output inverter transistor $Q_3$ is reduced, and the TTL inverter circuit of Fig. 6 has a sharp transfer characteristic as illustrated in Fig. 5.

Fig. 7 illustrates a TTL inverter circuit as a third embodiment of the present invention. The TTL inverter circuit of Fig. 7 comprises a driver transistor $Q_{71}$, whose base electrode is connected to the input terminal IN and whose collector electrode is connected to the positive voltage source $V_{cc}$ through a resistor $R_{71}$. The TTL inverter circuit of Fig. 7 also comprises an output inverter transistor $Q_{72}$, whose base electrode is connected to the emitter electrode of the driver transistor $Q_{71}$, whose emitter electrode is grounded and whose collector electrode is connected to the output terminal OUT and to the positive voltage source $V_{cc}$ through a resistor $R_{72}$. The TTL inverter circuit of Fig. 7 comprises a switching transistor $Q_{73}$ whose main current path is connected between the base electrode and the emitter electrode of the output inverter transistor $Q_{72}$ and whose base electrode is connected, through a capacitor $C_{71}$, to a terminal P connected to a predetermined node in the circuit of Fig. 7. The switching transistor $Q_{73}$ is turned on due to the temporary supply of the base current through the capacitor $C_{71}$ when the output inverter transistor $Q_{72}$ changes from the turned on condition to the turned off condition. Therefore, the base charge stored in the base region of the output inverter transistor $Q_{72}$ is quickly discharged through the main current path of the switching transistor $Q_{73}$, as illustrated by an arrow d in Fig. 7, so that the turn off time of the output inverter transistor $Q_{72}$ is reduced. Therefore, the terminal P is connected to one of the nodes of the circuit of Fig. 7, the potential of which changes from low to high when the output inverter transistor $Q_{72}$ changes from the turned on condition to the turned off condition. For example, the terminal P is connected to the collector electrode of the driver transistor $Q_{71}$ or the collector electrode of the output inverter transistor $Q_{72}$. A diode $D_{71}$ clamps the potential of the base electrode of the switching transistor $Q_{73}$ to the ground potential, when the potential of the terminal P changes from high level to low level, and ensures quick turn on of the switching transistor $Q_{73}$ when the potential of the terminal P changes from low level to high level. If the diode $D_{71}$ is not used, the potential of the base electrode of the switching transistor $Q_{73}$ falls to a very low level when the potential of the terminal P has changed from high to low, and thus, there is a possibility of missing or delaying the turn on of the switching transistor $Q_{73}$.

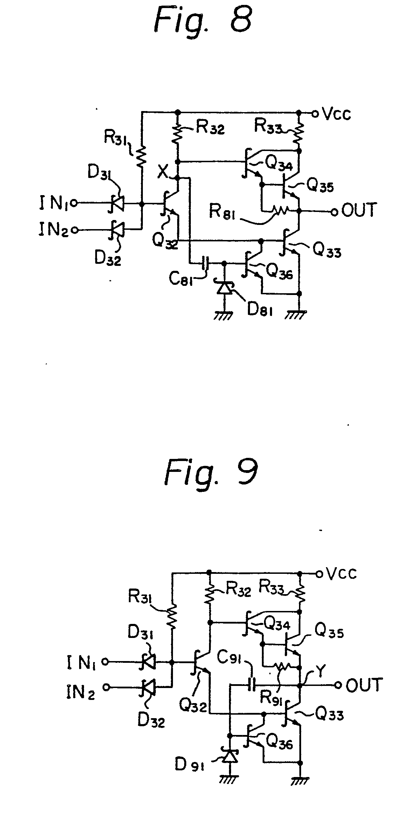

Fig. 8 illustrates a two input DTL NAND gate as a fourth embodiment of the present invention. The NAND gate of Fig. 8 is the same as the NAND gate of Fig. 3, except that the diodes $D_{33}$ and $D_{34}$ and the resistor $R_{35}$ included in the NAND gate of Fig. 3 are replaced by a capacitor $C_{81}$ and a Schottky barrier diode $D_{81}$. In Fig. 8, a terminal of the capacitor $C_{81}$, which corresponds to the terminal P of the circuit of Fig. 7, is connected to a node X, i.e., the collector electrode of the driver transistor $Q_{32}$. When the output inverter transistor $Q_{33}$ changes from the turned on condition to the turned off condition, the potential of the node X changes from low to high and the switching transistor $Q_{36}$ is turned on for a short time because the base current is temporarily supplied

through the capacitor $C_{81}$. Therefore, the base charge stored in the base region of the output inverter transistor $Q_{33}$ is quickly discharged and, as a result, the turn off time of the output inverter transistor $Q_{33}$ is reduced.

With regard to the transfer characteristic, since the NAND gate of Fig. 8 does not have a resistor corresponding to the resistor $R_5$ contained in the conventional fundamental logic circuit of Fig. 1, the driver transistor $Q_{32}$ and the output inverter transistors $Q_{33}$ turn on or turn off at substantially the same time. Therefore, the NAND gate of Fig. 8 has as sharp a transfer characteristic as that of the logic circuit of Fig. 4.

The threshold voltage $V_{TH}$ of each of the input potentials $V_{IN1}$ and $V_{IN2}$ of the NAND gate of Fig. 8 is as given by the following equation.

$$V_{TH} = V_{BE32} + V_{BE33} - V_F \fallingdotseq 1.2 \text{ V} \qquad (2)$$

where $V_{BE32}$ and $V_{BE33}$ are base-emitter voltages of the driver transistor $Q_{32}$ and the output inverter transistor $Q_{33}$, respectively, and $V_F$ is a forward biased voltage of the diode $D_{31}$ or $D_{32}$. Therefore, the threshold voltage $V_{TH}$ becomes about 1.2 V, and is higher than that of the conventional logic circuit of Fig. 3, so that a high noise immunity is obtained.

The NAND gate of Fig. 8 also has the following two advantages. One of the advantages is low power consumption in a steady state. This advantage is obtained because the base current of the switching transistor $Q_{36}$ flows only temporarily through the capacitor $C_{81}$ when the output inverter transistor $Q_{33}$ changes from the turned on condition to the turned off condition. The other of the advantages is that the NAND gate of Fig. 8 does not occupy a large area in an integrated circuit. This is because the NAND gate of Fig. 8 does not use a large number of parts and the capacitor $C_{81}$, contained in the NAND gate of Fig. 8, can be formed by using a multi layer pattern in an integrated circuit.

Fig. 9 illustrates another two input DTL NAND gate as a fifth embodiment of the present invention. The NAND gate of Fig. 9 is the same as the NAND gate of Fig. 8, except that the terminal of a capacitor $C_{91}$, which corresponds to the capacitor $C_{81}$ in Fig. 8, is connected to a node Y, i.e., the output terminal OUT of the NAND gate of Fig. 9. The potential of the node Y changes from low to high when the output inverter transistor $Q_{33}$ changes from the turned on condition to the turned off condition. Therefore, operation of the NAND gate of Fig. 9 is the same as that of the NAND gate of Fig. 8, and the NAND gate of Fig. 9 has the same advantage as that of the NAND gate of Fig. 8.

**Claims**

1. A logic circuit for performing a logical operation comprising:
an input means;
a driver transistor (Q2) whose base electrode is connected to the input means;
an output emitter-follower transistor means (Q4, Q5) which is driven by an output signal from the collector electrode of the driver transistor (Q2);
an output inverter transistor (Q3) which is driven by an output signal from the emitter electrode of the driver transistor (Q2) and which, with the output emitter follower transistor means constitutes a totem-pole output stage; and
a first switching transistor (Q6) which is connected between the base electrode of the output inverter transistor and ground, and which removes a base charge from the base of the output inverter transistor (Q3);
characterized by a second switching transistor (Q7) of which the emitter-collector path is connected between the base electrode of the first switching transistor (Q6) and a node of the logic circuit which changes in potential with the output electrode of the driver transistor more rapidly than the change in potential at the output of the output inverter transistor (Q3) when the output inverter transistor changes from the conductive state to the non-conductive state the said second switching transistor being switched to its conductive state temporarily when the output inverter transistor (Q3) changes from the conductive state to the non-conductive state.

2. A logic circuit as set forth in claim 1, characterized in that the said node of the logic circuit is the collector electrode of the driver transistor (Q2, Figure 4), the base electrode of the second switching transistor (Q7) being connected to an emitter electrode of the output emitter-follower transistor means (Q4, Q5).

3. A logic circuit as set forth in claim 2, characterized in that the output emitter-follower transistor means is a Darlington transistor device consisting of first (Q4) and second (Q5) transistors, the base electrode of the said second switching transistor (Q7) being connected to the emitter electrode of the first transistor (Q4) of the Darlington transistor device.

4. A logic circuit as set forth in claim 1, characterised in that the output emitter-follower transistor means is a Darlington transistor device consisting of first (Q4) and second (Q5) transistors, and in which the said node of the logic circuit is the emitter electrode of the first transistor (Q4, Figure 6) of the Darlington transistor device, the base electrode of the second switching transistor (Q7) being connected to the output terminal of the logic circuit.

5. A logic circuit for performing a logical operation, comprising:
an input means;
a driver transistor (Q71, Figure 7 or Q32, Figures 8 and 9) whose base electrode is connected to the input means;
an output inverter transistor (Q72 or Q33) which is driven by an output signal from the emitter electrode of the driver transistor;
a switching transistor (Q73 or Q36) which is connected between the base electrode of the output inverter transistor and ground, and which removes a base charge from the base of the output inverter transistor;

characterized in that a capacitor (C71, C81, or C91) is connected between the base electrode of the switching transistor and a node (X or Y) in the circuit which changes in potential as the state of conduction of the output inverter transistor changes, in such a manner that when the output inverter transistor changes from the conductive state to the non-conductive state the capacitor provides a temporary supply of base current to the switching transistor (Q73 or Q36) to cause the switching transistor to switch to the conductive state temporarily to remove the stored base charge of the output inverter transistor (Q73 or Q33); and in that a diode (D71, D81, or D91) is connected between the base electrode of the switching transistor and ground to clamp the base potential of the switching transistor when the potential of the said node changes in the opposite sense.

6. A logic circuit as set forth in claim 5, characterized in that the said node of the logic circuit is the collector electrode (X) of the driver transistor.

7. A logic circuit as set forth in claim 5, characterized in that the said node of the logic circuit is the collector electrode (Y) of the output inverter transistor.

8. A logic circuit as set forth in claim 5, 6, or 7 characterized in that the logic circuit further comprises output emitter-follower transistor means (Q34, Q35) driven by an output signal from the collector electrode of the driver transistor and which, together with the output inverter transistor, constitutes a totem-pole output stage.

9. A logic circuit as set forth in claim 8 characterized in that the output emitter-follower transistor means is a Darlington transistor circuit consisting of two transistors (Q34, Q35).

**Patentansprüche**

1. Logische Schaltung zur Durchführung eines logischen Betriebs, mit:

einer Eingangseinrichtung;

einem Treibertransistor (Q2), dessen Basiselektrode mit der Eingangseinrichtung verbunden ist;

einer Ausgangs-Emitterfolgetransistoreinrichtung (Q4, Q5), die von einem Ausgangssignal von der Kollektorelektrode des Treibertransistors (Q2) getrieben wird;

einem Ausgangsinvertertransistor (Q3), der durch ein Ausgangssignal von der Emitterelektrode des Treibertransistors (Q2) getrieben wird und der, mit der Ausgangs-Emitterfolgetransistoreinrichtung eine Totempfahl-Ausgangsstufe bildet; und

einem ersten Schalttransistor (Q6), der zwischen der Basiselektrode des Ausgangsinvertertransistors und Erde angeschlossen ist und der eine Basisladung von der Basis der Ausgangsinvertertransistors (Q3) entfernt;

gekennzeichnet durch einen zweiten Schalttransistor (Q7), dessen Emitter-Kollektor-Weg zwischen der Basiselektrode des ersten Schalttransistors (Q6) und einem Knotenpunkt der Logikschaltung verbunden ist, dessen Potential sich mit der Ausgangselektrode des Treibertransistors schneller ändert als die Potentialänderung an dem Ausgang des Ausgangsinvertertransistors (Q3), wenn der Ausgangsinvertertransistor von dem leitenden Zustand in den nicht leitenden Zustand übergeht, wobei der genannte zweite Schalttransistor temporär in seinen leitenden Zustand geschaltet wird, wenn der Ausgangsinvertertransistor (Q3) von dem leitenden Zustand in den nicht leitenden Zustand wechselt.

2. Logikschaltung nach Anspruch 1, dadurch gekennzeichnet, daß der genannte Knotenpunkt der Logikschaltung die Kollektorelektrode des Treibertransistors (Q2, Figur 4) ist, die Basiselektrode des zweiten Schalttransistors (Q7) mit einer Emitterelektrode der Ausgangs-Emitterfolgetransistoreinrichtung (Q4, Q5) verbunden ist.

3. Logikschaltung nach Anspruch 2, dadurch gekennzeichnet, daß die Ausgangs-Emitterfolgetransistoreinrichtung eine Darlington-Transistoreinrichtung ist, die aus ersten (Q4) und zweiten (Q5) Transistoren besteht, wobei die Basiselektrode des genannten zweiten Schalttransistors (Q7) mit der Emitterelektrode des ersten Transistors (Q4) der Darlington-Transistoreinrichtung verbunden ist.

4. Logikschaltung nach Anspruch 1, dadurch gekennzeichnet, daß die Ausgangs-Emitterfolgetransistoreinrichtung eine Darlington-Transistoreinrichtung ist, die aus ersten (Q4) und zweiten (Q5) Transistoren besteht und bei der der genannte Knotenpunkt der Logikschaltung die Emitterelektrode des ersten Transistors (Q4, Figur 6) der Darlington-Transistoreinrichtung ist, wobei die Basiselektrode des zweiten Schalttransistors (Q7) mit dem Ausgangsanschluß der Logikschaltung verbunden ist.

5. Logikschaltung zur Durchführung eines logischen Betriebs, mit:

einer Eingangseinrichtung;

einem Treibertransistor (Q71, Figur 7 oder Q32, Figuren 8 und 9), dessen Basiselektrode mit der Eingangseinrichtung verbunden ist;

einem Ausgangsinvertertransistor (Q72 oder Q33), der durch ein Ausgangssignal von der Emitterelektrode des Treibertransistors getrieben wird;

einem Schalttransistor (Q73 oder Q36), der zwischen der Basiselektrode des Ausgangsinvertertransistors und Erde angeschlossen ist und der eine Basisladung von dem Ausgangsinvertertransistor entfernt;

dadurch gekennzeichnet, daß ein Kondensator (C71, C81, oder C91) zwischen der Basiselektrode des Schalttransistors und einem Knotenpunkt (X oder Y) in der Schaltung verbunden ist, dessen Potential sich ändert, wenn der Zustand der Leitung des Ausgangsinvertertransistors sich ändert, auf solche Weise, daß dann, wenn der Ausgangsinvertertransistor von dem leitenden Zustand in den nicht leitenden Zustand übergeht, der Kondensator eine temporäre Lieferung des Basisstromes zu dem Schalttransistor (Q73 oder Q36) vorsieht, um zu verursachen, daß der Schalttransistor temporär in den leitenden Zustand schaltet, um die gespeicherte Basisladung des Ausgangsinvertertransistors (Q73 oder Q33) zu entfernen; und daß eine Diode (D71, D81 oder D91) zwischen der Basiselektrode des Basisschalttransistors eine Erde verbunden ist, um das Basispotential des Schaltransistors zu klammern, wenn das Potential des genannten Knotens sich in entgegengesetztem Sinne ändert.

6. Logikschaltung nach Anspruch 5, dadurch gekennzeichnet, daß der genannte Knotenpunkt der Logikschaltung die Kollektorelektrode (X) des Treibertransistors ist.

7. Logikschaltung nach Anspruch 5, dadurch gekennzeichnet, daß der genannte Knotenpunkt der Logikschaltung die Kollektorelektrode (Y) des Ausgangsinvertertransistors ist.

8. Logische Schaltung nach Anspruch 5, 6 oder 7, dadurch gekennzeichnet, daß die logische Schaltung ferner eine Ausgangs-Emitterfolgetransistoreinrichtung (Q34, Q35) umfaßt, die von einem Ausgangssignal von der Kollektorelektrode des Treibertransistors getrieben wird und welche, zusammen mit dem Ausgangsinvertertransistor, eine Totempfahl-Ausgangsstufe bildet.

9. Logische Schaltung nach Anspruch 8, dadurch gekennzeichnet, daß die Ausgangs-Emitterfolgetransistoreinrichtung ein Darlington-Transistorschaltung ist, die aus zwei Transistoren (Q34, Q35) besteht.

**Revendications**

1. Circuit logique destiné à effectuer une opération logique, comportant: un dispositif d'entrée; un transistor d'attaque (Q2) dont l'électrode de base est connectée au dispositif d'entrée; un transistor de sortie à charge d'émetteur (Q4, Q5) commandé par un signal de sortie provenant de l'électrode de collecteur du transistor d'attaque (Q2); un transistor inverseur de sortie (Q3) qui est commandé par un signal de sortie provenant de l'électrode d'émetteur du transistor d'attaque (Q2), et qui, avec le transistor de sortie à charge d'émetteur, constitue un étage de sortie unipolaire; et un premier transistor de commutation (Q6) qui est connecté entre l'électrode de base du transistor inverseur de sortie et la masse et qui élimine une charge de base de la base du transistor inverseur de sortie (Q3); caractérisé par un second transistor de commutation (Q7) dont le circuit émetteur-collecteur est connecté entre l'électrode de base du premier transistor de commutation (Q6) et un point de jonction du circuit logique dont le potentiel change avec l'électrode de sortie du transistor d'attaque plus rapidement que le changement de potentiel à la sortie du transistor inverseur de sortie (Q3) quand le transistor inverseur de sortie passe de l'état conducteur à l'état non conducteur, ledit second transistor de commutation étant placé dans son état conducteur momentanément quand le transistor inverseur de sortie (Q3) passe de l'état conducteur à l'état non conducteur.

2. Circuit logique selon la revendication 1, caractérisé en ce que ledit point de jonction du circuit logique est l'électrode de collecteur du transistor d'attaque (Q2, Fig. 4), l'électrode de base du second transistor de commutation (Q7) étant connectée à une électrode d'émetteur du transistor de sortie à charge d'émetteur (Q4, Q5).

3. Circuit logique selon la revendication 2, caractérisé en ce que le transistor de sortie à charge d'émetteur est un transistor Darlington comprenant un premier (Q4) et un second (Q5) transistor, l'électrode de base dudit second transistor de commutation (Q7) étant connectée à l'électrode d'émetteur du premier transistor (Q4) du transistor Darlington.

4. Circuit logique selon la revendication 1, caractérisé en ce que le transistor de sortie à charge d'émetteur est un transistor Darlington comprenant un premier (Q4) et un second (Q5) transistor et dans lequel ledit point de jonction du circuit logique est l'électrode d'émetteur du premier transistor (Q4, Fig. 6) du transistor Darlington, l'électrode de base du second transistor de commutation (Q7) étant connectée à la borne de sortie du circuit logique.

5. Circuit logique destiné à effectuer une opération logique, comportant: un dispositif d'entrée; un transistor d'attaque (Q71, Fig. 7 ou Q32, Figs. 8 et 9) dont l'électrode de base est connectée au dispositif d'entrée; un transistor inverseur de sortie (Q72 ou Q33) qui est commandé par un signal de sortie provenant de l'électrode d'émetteur du transistor d'attaque; un transistor de commutation (Q73 ou Q36) qui est connecté entre l'électrode de base du transistor inverseur de sortie et la masse et qui élimine une charge de base de la base du transistor inverseur de sortie; caractérisé en ce qu'un condensateur (C71, C81 ou C91) est connecté entre l'électrode de base du transistor de commutation et un point de jonction (X ou Y) dans le circuit qui change de potentiel quand l'état de conduction du transistor inverseur de sortie change de manière que lorsque le transistor inverseur de sortie passe de l'état conducteur à l'état non conducteur, le condensateur fournisse momentanément un courant de base au transistor de commutation (Q73 ou Q36) pour que le transistor de commutation passe à l'état conducteur momentanément afin d'éliminer la charge de base emmagasinée du transistor inverseur de sortie (Q73 ou Q33); et en ce qu'une diode (D71, D81 ou D91) est connectée entre l'électrode de base du transistor de commutation et la masse pour fixer le niveau du potentiel de base du transistor de commutation quand le potentiel dudit point de jonction change dans le sens opposé.

6. Circuit logique selon la revendication 5, caractérisé en ce que ledit point de jonction du circuit logique est l'électrode de collecteur (X) du transistor d'attaque.

7. Circuit logique selon la revendication 5, caractérisé en ce que ledit point de jonction du circuit logique est l'électrode de collecteur (Y) du transistor inverseur de sortie.

8. Circuit logique selon la revendication 5, 6 ou 7 caractérisé en ce que le circuit logique comporte en outre un transistor de sortie à charge d'émetteur (Q34, Q35) commandé par un signal de sortie provenant de l'électrode de collecteur du transistor d'attaque et qui, avec le transistor inverseur de sortie, constitue un étage de sortie unipolaire.

9. Circuit logique selon la revendication 8, caractérisé en ce que le transistor de sortie à charge d'émetteur est un transistor Darlington comprenant deux transistors (Q34, Q35).

**0 026 051**

*Fig. 1*

*Fig. 2*

*Fig. 3*

1

# Fig. 4

# Fig. 5

0 026 051

# Fig. 6

# Fig. 7

3

## Fig. 8

## Fig. 9